# EUROPÄISCHE PATENTSCHRIFT

(11) **EP 2 075 220 B1**
(45) Veröffentlichungstag und Bekanntmachung des Hinweises auf die Patenterteilung: **03.06.2015**
(21) Anmeldenummer: 08105777.0
(22) Anmeldetag: 12.11.2008
(51) Int. Cl.: B81B 3/00

(54) **Mikromechanisches Bauelement mit reduziertem Stressgradient**
Micromechanical element with reduced stress gradient
Element micromécanique avec une gradient de stress réduit

(30) Priorität: 27.12.2007 DE 102007062707
(43) Veröffentlichungstag der Anmeldung: 01.07.2009
(73) Patentinhaber: Robert Bosch GmbH, 70442 Stuttgart (DE)
(72) Erfinder: Baumann, Helmut, 72810, Gomaringen (DE); Scheuerer, Roland, 72768, Reutlingen (DE); Weber, Heribert, 72622, Nuertingen (DE)

(56) Entgegenhaltungen:
- EP-A2- 0 663 692
- US-A1- 2005 127 792

## Beschreibung

### Stand der Technik

Die Erfindung geht aus von einem mikromechanischen Bauelement nach dem Oberbegriff des Anspruchs 1.

Solche mikromechanischen Bauelemente sind allgemein bekannt. Beispielsweise ist aus der Druckschrift DE 100 17 976 A1 ein mikromechanisches Bauelement mit einem Substrat und einer eine Sensorstruktur umfassende mikromechanische Funktionsschicht bekannt, wobei die Funktionsschicht polykristalline Bereiche aufweist, welche epitaktisch auf einer darunterliegenden polykristallinen Startschicht auf dem Substrat aufgewachsen sind. Nachteilig daran ist, dass derartige bewegliche Sensorstrukturen in Abhängigkeit ihres Herstellungsverfahrens vergleichsweise große Zug- bzw. Druckspannungen aufweisen, welche mit zunehmenden vertikalen Schichtdicken der beweglichen Sensorstrukturen, senkrecht zur Haupterstreckungsebene des Substrats, deutlich zunehmen. Somit weisen diese beweglichen Strukturen einen sogenannten "Stressgradient" über die Schichtdicke auf, welcher zu Verformungen der beweglichen Sensorstrukturen führen. Insbesondere die frei beweglichen Randbereiche der beweglichen Sensorstruktur werden dabei in einer vertikalen Richtung verformt. Dies ist höchst unerwünscht, da zur empfindlichen Messung der Auslenkung der beweglichen Sensorstruktur ein präzise definierter Abstand der beweglichen Sensorstruktur zu einer festen Struktur notwendig ist, insbesondere bei der Verwendung von kapazitiven Messverfahren.

### Offenbarung der Erfindung

Das erfindungsgemäße mikromechanische Bauelement und das erfindungsgemäße Verfahren zur Herstellung eines mikromechanischen Bauelements gemäß den nebengeordneten Ansprüchen, haben gegenüber dem Stand der Technik den Vorteil, dass die bewegliche Struktur aufgrund des geschichteten Aufbaus sowohl in lateraler, als auch in vertikaler Richtung stressoptimiert ist. Der Stressgradient in einer aufgewachsenen mikromechanischen Funktionsschicht wird durch ein unterschiedliches Kristallwachstum über die Schichtdicke der mikromechanischen Funktionsschicht senkrecht zu einer Haupterstreckungsebene des Substrats bei der Herstellung der mikromechanischen Funktionsschicht verursacht. Beispielsweise wird zum Aufwachsen einer Siliziumschicht in einem Epitaxiereaktor eine Startschicht verwendet, wobei auf der Startschicht das Silizium zunächst polykristallin aufwächst und im weiteren Verlauf des Aufwachsprozesses das Silizium sein Aufwachsverhalten immer mehr in Richtung eines kristallinen Aufwachsens verändert. Hierbei muss die Richtung des Kristallwachstums nicht zwingend senkrecht zur Startschicht erfolgen, vielmehr ist auch ein bezüglich der Startschicht schräg nach oben gerichtetes Kristallwachstum möglich. Dieses von der Schichtdicke der aufwachsenden Schicht abhängiges Aufwachsverhalten bewirkt eine inhomogene Stressverteilung über die aufgewachsene Schichtdicke und nimmt mit zunehmenden Schichtdicken deutlich zu. Das erfindungsgemäße mikromechanische Bauelement weist eine Mehrzahl von Startschichten auf, so dass die auf den Startschichten jeweils aufgewachsenen Schichten eine im Vergleich zum Stand der Technik deutlich geringere Schichtdicke aufweisen und somit die Inhomogenität des Stressgradients in erheblicher Weise reduziert wird. Insbesondere wird beim Abscheiden von Silizium ein zunehmend kristallorientiertes Siliziumwachstum vermieden. Daher wird eine Realisation einer beweglichen Struktur mit vergleichsweise großer Schichtdicke und gleichzeitig geringer Inhomogenität des Stressgradienten über die Schichtdicke ermöglicht, so dass entlang der beweglichen Struktur, welche insbesondere freitragend ausgebildet ist, keine oder nur eine vergleichsweise geringe Verformung auftritt. Die bewegliche Struktur umfasst vorzugsweise bewegliche Fingerstrukturen und/oder bewegliche Wippen einer mikromechanischen Funktionsschicht und/oder deren Aufhängung.

Vorteilhafte Ausgestaltungen und Weiterbildungen der Erfindung sind den Unteransprüchen, sowie der Beschreibung unter Bezugnahme auf die Zeichnungen entnehmbar.

Erfindungsgemäß ist vorgesehen, dass die weiteren Startschichten und die weiteren Schichten polykristallines Silizium umfassen und/oder dass das Substrat, die weiteren Startschichten und/oder die weiteren Schichten einkristallines Silizium umfassen. Vorteilhafterweise wird somit ein Aufbringen der Schicht aus Silizium und/oder der weiteren Schicht aus Silizium durch Abscheidung in einem Epitaxiereaktor ermöglicht, wobei insbesondere zeitlich vor jedem Abscheiden einer weiteren Schicht aus Silizium eine polykristalline weitere Startschicht auf die vorhergehende Schicht oder auf die weitere Schicht aus Silizium aufgebracht wird. Die Herstellung des mikromechanischen Bauelements ist somit in besonders vorteilhafter Weise in Standardhersfellungsverfahren realisierbar. Ganz besonders bevorzugt wird Zeitgleich die Herstellung sowohl einer monokristallinen, als auch einer polykristallinen Siliziumschicht ermöglicht.

Gemäß einer weiteren bevorzugten Weiterbildung ist vorgesehen, dass die bewegliche Struktur zumindest teilweise unterätzte Bereiche aufweist. Besonders vorteilhaft wird durch das Unterätzen definierter Bereiche eine Beweglichkeit der beweglichen Struktur in einer vertikalen Richtung senkrecht zur Haupterstreckungsebene und/oder in einer lateralen Richtung in der Haupterstreckungsebene ermöglicht. Vorteilhafterweise ist somit eine bewegliche Struktur mit einem vergleichsweise langen lateralen unterätzten Bereich möglich da insbesondere bei derart langen freitragenden beweglichen Strukturen die Inhomogenitäten im Stressgradienten im Stand der Technik zu vergleichsweise starken lateralen und/oder vertikalen Verformungen der beweglichen Struktur führen.

Gemäß einer bevorzugten Weiterbildung ist vorgesehen, dass das Substrat zumindest teilweise in einer Projektionsfläche der beweglichen Struktur senkrecht zur Haupterstreckungsebene des Substrats wenigstens eine Ausnehmung aufweist. Besonders vorteilhaft wird durch diese Ausnehmung die Erzeugung der beweglichen Struktur ermöglicht, so dass eine maximale vertikale und/oder laterale Beweglichkeit der beweglichen Struktur in einfacher Weise gewährleistet wird.

Gemäß einer bevorzugten Weiterbildung ist vorgesehen, dass die bewegliche Struktur wenigstens eine Kompensationsschicht aufweist, welche bevorzugt im Bereich einer weiteren Startschicht und besonders bevorzugt zwischen einer weiteren Startschicht und einer senkrecht zur Haupterstreckungsrichtung in Richtung des Substrats angeordneten Schicht oder weiteren Schicht angeordnet ist. Vorteilhafterweise wirkt die Kompensationsschicht der Verwölbung bzw. der Verformung der beweglichen Struktur entgegen, so dass der Einfluss eines inhomogenen Stressgradienten weiter reduziert wird. Bevorzugt umfasst die Kompensationsschicht eine Siliziumoxidschicht und/oder eine Siliziumnitridschicht und/oder eine Siliziumcarbidschicht.

Gemäß einer weiteren bevorzugten Weiterbildung ist vorgesehen, dass das mikromechanische Bauelement einen Sensor und insbesondere einen Beschleunigungssensor, einen Drehratensensor, einen Membransensor und/oder einen Mikrospiegel umfasst.

Gemäß einer weiteren bevorzugten Weiterbildung ist vorgesehen, dass das bewegliche Element gegenüber dem Substrat elektrisch isoliert ist und/oder dass die Schichten dotiert sind und/oder dass die Schichten gleiche und/oder unterschiedliche Schichtdicken jeweils senkrecht zur Haupterstreckungsebene aufweisen, so dass vorteilhaft beispielsweise die Leitfähigkeit wenigstens einzelner Schichten zumindest teilweise erhöht wird und/oder die Strukturen an die Erfordernisse des mikromechanischen Bauelements variabel anzupassen bzw. auszubilden sind.

Ein weiterer Gegenstand der vorliegenden Erfindung ist ein Verfahren zur Herstellung eines mikromechanischen Bauelements, wobei in einem ersten Verfahrensschritt das Substrat bereitgestellt wird, wobei in einem zweiten Verfahrensschritt das Substrat zumindest teilweise mit der Startschicht versehen wird, wobei in einem dritten Verfahrensschritt die Schicht auf der Startschicht aufgebracht wird, wobei in einem vierten Verfahrensschritt die Schicht mit der weiteren Startschicht versehen wird und wobei in einem fünften Verfahrensschritt die weitere Schicht auf der weiteren Startschicht aufgebracht wird. Vorzugsweise werden somit zwei Schichten realisiert, welche ein vergleichsweise gleichmäßiges Aufwachsverhalten aufweisen, so dass die Inhomogenität des Stressgradienten in erheblicher Weise reduziert wird. Insbesondere besteht die bewegliche Struktur im Wesentlichen aus polykristallinen Siliziumschichten.

Gemäß einer weiteren bevorzugten Weiterbildung ist vorgesehen, dass im sechsten und im siebten Verfahrensschritt eine Mehrzahl von weiteren Startschichten und weiteren Schichten abwechselnd nacheinander aufgebracht werden. Vorzugsweise werden somit eine Vielzahl von weiteren Schichten mit jeweils vergleichsweise guter Homogenität des Stressgradienten zur Bildung einer verhältnismäßig dicken beweglichen Struktur realisiert, wobei eine Verwölbung bzw. Verformung der beweglichen Struktur verhindert wird und wobei jede weitere Schicht jeweils auf einer weiteren Startschicht aufgewachsen wird. Somit ist eine bewegliche Struktur einer vergleichsweise großen Gesamtdicke senkrecht zur Haupterstreckungsebene realisierbar, wobei die bewegliche Strukturen im Wesentlichen lediglich polykristallines Silizium aufweisen.

Gemäß einer weiteren bevorzugten Weiterbildung ist vorgesehen, dass in einem achten Verfahrensschritt eine Kompensationsschicht auf die Schicht oder auf eine weitere Schicht aufgebracht wird und/oder dass in einem neunten Verfahrensschritt die Startschicht oder eine weitere Startschicht strukturiert, dotiert, geätzt, getempert, aufgeraut und/oder poliert wird. Vorzugsweise wird die Verwölbung bzw. Verformung der beweglichen Struktur weiterhin durch die Kompensationsschicht oder durch eine Mehrzahl von Kompensationsschichten in der beweglichen Struktur verhindert. Das polykristalline Siliziumaufwachsen einer Schicht bzw. einer weiteren Schicht auf einer Startschicht bzw. auf einer weiteren Startschicht wird in vorteilhafterweise durch Tempern, Dotieren und/oder Rauhätzen der Startschicht bzw. der weiteren Startschicht begünstigt. Die Startschicht bzw. weitere Startschicht umfasst vorzugsweise eine vergleichsweise dünne polykristalline Schicht. Durch ein Strukturieren der Startschicht bzw. der weiteren Startschicht ist ein gleichzeitiges epitaktisches, sowie polykristallines Abscheiden der jeweiligen Schicht bzw. der jeweiligen weiteren Schicht möglich.

Gemäß einer weiteren bevorzugten Weiterbildung ist vorgesehen, dass in einem zehnten Verfahrensschritt die Ausnehmung in das Substrat geätzt wird, so dass in vergleichsweise einfacher Weise ein unterätzter Bereich des beweglichen Elements realisiert wird.

Gemäß einer weiteren bevorzugten Weiterbildung ist vorgesehen, dass in einem elften Verfahrensschritt die Schichten und/oder die weiteren Schichten zumindest teilweise dotiert werden, um in besonders vorteilhafter Weise die elektrische Leitfähigkeit einzustellen bzw. zu erhöhen.

Ausführungsbeispiele der Erfindung sind in den Zeichnungen dargestellt und in der nachfolgenden Beschreibung näher erläutert.

### Kurze Beschreibung der Zeichnung

Es zeigen
**Figur 1** eine schematische Seitenansicht eines mikromechanischen Bauelements gemäß dem Stand der Technik,
**Figur 2** eine schematische Seitenansicht eines mikromechanischen Bauelements gemäß einer ersten Ausführungsform der vorliegenden Erfindung und
**Figur 3** eine schematische Seitenansicht eines mikromechanischen Bauelements gemäß einer zweiten Ausführungsform der vorliegenden Erfindung.

### Ausführungsform(en) der Erfindung

In den verschiedenen Zeichnungen sind gleiche Teile stets mit den gleichen Bezugszeichen versehen und werden daher in der Regel auch jeweils nur einmal benannt.

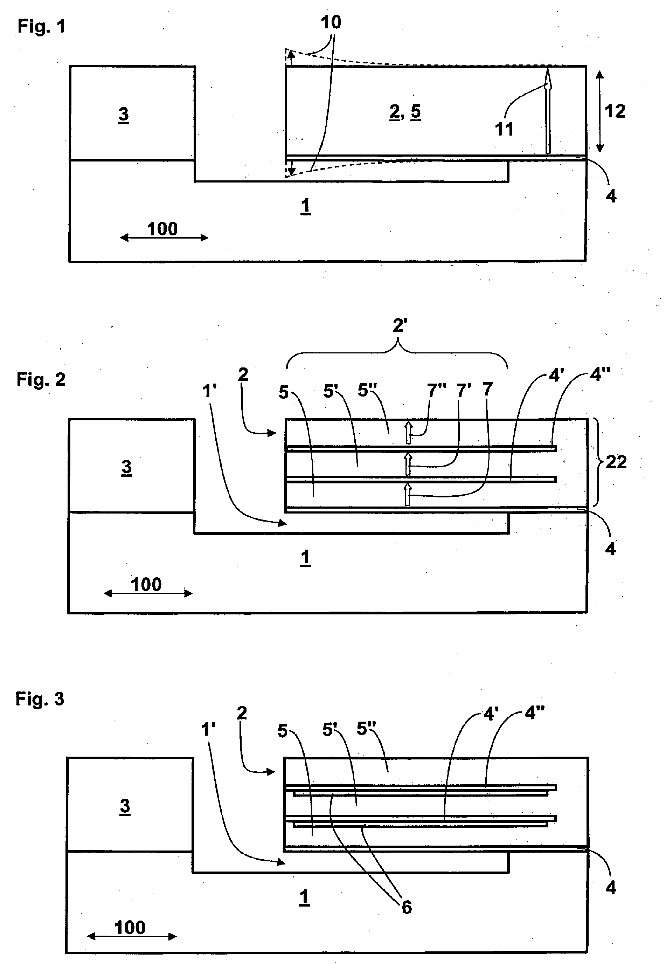

In **Figur 1** ist eine schematische Seitenansicht eines mikromechanischen Bauelements gemäß dem Stand der Technik dargestellt, wobei das mikromechanische Bauelement ein Substrat 1, eine monokristalline Siliziumschicht 3 und ein bewegliches Element 2 aufweist. Das bewegliche Element 2 besteht aus einer auf einer Startschicht 4 abgeschiedenen Siliziumschicht 5. Hierbei kann vorzugsweise die Startschicht 4 auch auf einer Isolatorschicht, beispielsweise einem Siliziumoxid, einem Siliziumnitrid und/oder einem Siliziumcarbid, auf dem Substrat 1 abgelegt werden, wodurch eine elektrische Isolation des beweglichen Elements 2 gegenüber dem Substrat 1 ermöglicht wird. Aufgrund der relativ großen Schichtdicke 12 der Startschicht 4 verändert sich das Aufwachsverhalten 11 der Siliziumschicht 5 von einem polykristallinen Aufwachsverhalten 11 mit zunehmender Schichtdicke 12 zu einem eher kristallinen Aufwachsverhalten 11, so dass der Stressgradient senkrecht zu einer Haupterstreckungsebene 100 des Substrats 1 vergleichsweise inhomogen ist. Dies führt zu einer Verformung 10 des überhängenden Bereiches insbesondere senkrecht zur Haupterstreckungsebene 100.

In **Figur 2** ist eine schematische Seitenansicht eines mikromechanischen Bauelements gemäß einer ersten Ausführungsform der vorliegenden Erfindung dargestellt, wobei das mikromechanisches Bauelement ein Substrat 1 und eine gegenüber dem Substrat 1 bewegliche Struktur 2 aufweist, wobei die bewegliche Struktur 2 eine erste, zweite und dritte Startschicht 4, 4', 4" und eine erste zweite und dritte Schicht 5, 5', 5" aufweist, wobei die erste Startschicht 4 auf das Substrat 1 aufgebracht ist, wobei die erste Schicht 5 auf der ersten Startschicht 4 aufgewachsen 7 ist, wobei auf der ersten Schicht 5 eine zweite Startschicht 4' aufgebracht ist, wobei die zweite Schicht 5' auf der zweiten Startschicht 4' aufgewachsen 7' ist, wobei auf der zweiten Schicht 5' eine dritte Startschicht 4" aufgebracht ist und wobei die dritte Schicht 5" auf der dritten Startschicht 4" aufgewachsen 7" ist. Die Aufwachsprozesse 7, 7', 7", welche zu den Schichten bzw. den weiteren Schichten 5, 5', 5" führen, umfassen vorzugsweise eine polykristalline Siliziumabscheidung, wobei auch die Startschichten bzw. die weiteren Startschichten 4, 4', 4" polykristallines Silizium umfassen. Ferner weist das mikromechanische Bauelement eine monokristalline Siliziumschicht 3 auf. Die bewegliche Struktur 2 weist einen unterätzten Bereich 2' auf, welcher durch eine in einer Projektionsfläche des unterätzten Bereiches 2' senkrecht zu einer Haupterstreckungsebene 100 des Substrats 1 im Substrat 1 ausgebildeten Ausnehmung 1' erzeugt wird. Durch den Schichtaufbau der beweglichen Struktur 2, welcher senkrecht zur Haupterstreckungsebene 100 eine vergleichsweise große Dicke 22 aufweist, aus aufeinandergeschichteten Schichten bzw. weiteren Schichten 5, 5', 5", welche jeweils eine deutlich geringere Dicke senkrecht zur Haupterstreckungsebene 100 aufweisen, wird die Inhomogenität des Stressgradienten und somit die Verformung 10 des unterätzten Bereiches 2' des beweglichen Elements 2 deutlich reduziert.

In **Figur 3** ist eine schematische Seitenansicht eines mikromechanischen Bauelements gemäß einer zweiten Ausführungsform der vorliegenden Erfindung dargestellt, wobei die zweite Ausführungsform im Wesentlichen identisch der ersten Ausführungsform ist, wobei im Bereich der zweiten und dritten Startschichten 4', 4" bzw. der weiteren Startschichten 4', 4" Kompensationsschichten 6 angeordnet sind, welche die Verformung 10 des unterätzten Bereichs 2' des beweglichen Elements 2 weiter reduzieren. Die Kompensationsschichten 6 sind insbesondere in einem Teilbereich zwischen der ersten Schicht 5 und der zweiten Startschicht 4', sowie in einem weiteren Teilbereich zwischen der zweiten Schicht 5' und der dritten Startschicht 4" angeordnet.

## Patentansprüche

1. Mikromechanisches Bauelement mit einem Substrat (1) und einer gegenüber dem Substrat (1) beweglichen Struktur (2), wobei die bewegliche Struktur (2) eine Startschicht (4) und eine auf der Startschicht (4) aufgewachsene Schicht (5) aufweist, **dadurch gekennzeichnet, dass** die bewegliche Struktur (2) wenigstens eine weitere Startschicht (4') und eine auf der weiteren Startschicht (4') aufgewachsene weitere Schicht (5') aufweist, wobei die weiteren Startschichten (4', 4") und die weiteren Schichten (5', 5") polykristallines Silizium umfassen oder das Substrat (1), die weiteren (4', 4") Startschichten und/oder die weiteren Schichten (5', 5") einkristallines Silizium umfassen.

2. Mikromechanisches Bauelement nach Anspruch 1, **dadurch gekennzeichnet, dass** die bewegliche Struktur (2) eine Mehrzahl von weiteren Startschichten (4', 4") und eine Mehrzahl von auf den weiteren Startschichten (4', 4") jeweils aufgewachsenen weiteren Schichten (5', 5") umfasst.

3. Mikromechanisches Bauelement nach einem der vorhergehenden Ansprüche, **dadurch gekennzeichnet, dass** die bewegliche Struktur (2) zumindest teilweise unterätzte Bereiche (2') aufweist.

4. Mikromechanisches Bauelement nach einem der vorhergehenden Ansprüche, **dadurch gekennzeichnet, dass** das Substrat (1) zumindest teilweise in einer Projektionsfläche der beweglichen Struktur senkrecht zu einer Haupterstreckungsebene (100) des Substrats wenigstens eine Ausnehmung (1') aufweist.

5. Mikromechanisches Bauelement nach einem der vorhergehenden Ansprüche, **dadurch gekennzeichnet, dass** die bewegliche Struktur (2) wenigstens eine Kompensationsschicht (6), bevorzugt aus Siliziumoxid, Siliziumnitrid und/oder Siliziumcarbid aufweist, welche bevorzugt im Bereich einer weiteren Startschicht (4', 4") und besonders bevorzugt zwischen einer weiteren Startschicht (4', 4") und einer senkrecht zur Haupterstreckungsebene (100) in Richtung des Substrats (2) angeordneten Schicht (5) oder weiteren Schicht (5', 5") angeordnet ist.

6. Mikromechanisches Bauelement nach einem der vorhergehenden Ansprüche, **dadurch gekennzeichnet, dass** das mikromechanische Bauelement einen Sensor und insbesondere einen Beschleunigungssensor, einen Drehratensensor, einen Membransensor und/oder einen Mikrospiegel umfasst.

7. Mikromechanisches Bauelement nach einem der vorhergehenden Ansprüche, **dadurch gekennzeichnet, dass** das bewegliche Element (2) gegenüber dem Substrat (2) elektrisch isoliert ist.

8. Mikromechanisches Bauelement nach einem der vorhergehenden Ansprüche, **dadurch gekennzeichnet, dass** die Schichten (5, 5', 5") dotiert sind und/oder dass die Schichten (5, 5', 5") gleiche oder unterschiedliche Schichtdicken jeweils senkrecht zur Haupterstreckungsebene (100) aufweisen.

9. Verfahren zur Herstellung eines mikromechanischen Bauelements gemäß einem der vorhergehenden Ansprüche, **dadurch gekennzeichnet, dass** in einem ersten Verfahrensschritt das Substrat (1) bereitgestellt wird, wobei in einem zweiten Verfahrensschritt das Substrat (1) zumindest teilweise mit der Startschicht (4) versehen wird, wobei in einem dritten Verfahrensschritt die Schicht (5) auf der Startschicht (4) aufgebracht wird, wobei in einem vierten Verfahrensschritt die Schicht (5) mit der weiteren Startschicht (4') versehen wird und wobei in einem fünften Verfahrensschritt die weitere Schicht (5') auf der weiteren Startschicht (4') aufgebracht wird.

10. Verfahren nach Anspruch 9, **dadurch gekennzeichnet, dass** im sechsten und im siebten Verfahrensschritt eine Mehrzahl von weiteren Startschichten (4', 4") und weiteren Schichten (5', 5") abwechselnd nacheinander aufgebracht werden.

11. Verfahren nach einem der Ansprüche 9 oder 10, **dadurch gekennzeichnet, dass** in einem achten Verfahrensschritt eine Kompensationsschicht auf die Schicht (5) oder auf eine weitere Schicht (5', 5") aufgebracht wird und/oder dass in einem neunten Verfahrensschritt die Startschicht (4) oder eine weitere Startschicht (4', 4") strukturiert, dotiert, geätzt, getempert, aufgeraut und/oder poliert wird.

12. Verfahren nach einem der Ansprüche 9 bis 11, **dadurch gekennzeichnet, dass** in einem zehnten Verfahrensschritt die Ausnehmung (1') in das Substrat (1) geätzt wird.

13. Verfahren nach einem der Ansprüche 9 bis 12, **dadurch gekennzeichnet, dass** in einem elften Verfahrensschritt die Schichten und/oder die weiteren Schichten (5, 5', 5") zumindest teilweise dotiert werden.

## Claims

1. Micromechanical component having a substrate (1) and a structure (2) which is movable with respect to the substrate (1), the movable structure (2) having a starting layer (4) and a layer (5) grown on the starting layer (4), **characterized in that** the movable structure (2) has at least one further starting layer (4') and one further layer (5') grown on the further starting layer (4'), the further starting layers (4', 4") and the further layers (5', 5") comprising polycrystalline silicon, or the substrate (1), the further starting layers (4', 4") and/or the further layers (5', 5") comprising monocrystalline silicon.

2. Micromechanical component according to Claim 1, **characterized in that** the movable structure (2) comprises a plurality of further starting layers (4', 4") and a plurality of further layers (5', 5") respectively grown on the further starting layers (4', 4").

3. Micromechanical component according to either of the preceding claims, **characterized in that** the movable structure (2) has at least partially undercut regions (2').

4. Micromechanical component according to one of the preceding claims, **characterized in that** the substrate (1) has at least one recess (1') at least partially in a projection surface of the movable structure perpendicular to a main extension plane (100) of the substrate.

5. Micromechanical component according to one of the preceding claims, **characterized in that** the movable structure (2) has at least one compensation layer (6), preferably consisting of silicon oxide, silicon nitride and/or silicon carbide, which is arranged preferably in the region of a further starting layer (4', 4") and particularly preferably between a further starting layer (4', 4") and a layer (5) or further layer (5', 5") arranged perpendicular to the main extension plane (100) in the direction of the substrate (2).

6. Micromechanical component according to one of the preceding claims, **characterized in that** the micromechanical component comprises a sensor and in particular an acceleration sensor, a rate-of-rotation sensor, a membrane sensor and/or a micromirror.

7. Micromechanical component according to one of the preceding claims, **characterized in that** the movable element (2) is electrically insulated with respect to the substrate (2).

8. Micromechanical component according to one of the preceding claims, **characterized in that** the layers (5, 5', 5") are doped and/or **in that** the layers (5, 5', 5") have the same or different layer thicknesses in each case perpendicular to the main extension plane (100).

9. Method for producing a micromechanical component according to one of the preceding claims, **characterized in that**, in a first method step, the substrate (1) is provided, the substrate (1) being provided at least partially with the starting layer (4) in a second method step, the layer (5) being applied to the starting layer (4) in a third method step, the layer (5) being provided with the further starting layer (4') in a fourth method step, and the further layer (5') being applied to the further starting layer (4') in a fifth method step.

10. Method according to Claim 9, **characterized in that** a plurality of further starting layers (4', 4") and further layers (5', 5") are applied alternately in succession in the sixth and in the seventh method step.

11. Method according to either of Claims 9 and 10, **characterized in that** a compensation layer is applied to the layer (5) or to a further layer (5', 5") in an eighth method step and/or **in that** the starting layer (4) or a further starting layer (4', 4") is patterned, doped, etched, heat-treated, roughened and/or polished in a ninth method step.

12. Method according to one of Claims 9 to 11, **characterized in that** the recess (1') is etched into the substrate (1) in a tenth method step.

13. Method according to one of Claims 9 to 12, **characterized in that** the layers and/or the further layers (5, 5', 5") are at least partially doped in an eleventh method step.

## Revendications

1. Composant micromécanique comportant un substrat (1) et une structure mobile (2) par rapport au substrat (1), dans lequel la structure mobile (2) comporte une couche de départ (4) et une couche (5) formée par croissance sur la couche de départ (4), **caractérisé en ce que** la structure mobile (2) comporte au moins une couche de départ supplémentaire (4') et une couche supplémentaire (5') formée par croissance sur la couche de départ supplémentaire (4'), dans lequel les couches de départ supplémentaires (4', 4") et les couches supplémentaires (5', 5") comprennent du silicium polycristallin ou dans lequel le substrat (1), les couches de départ supplémentaires (4', 4") et/ou les couches supplémentaires (5', 5") comprennent du silicium monocristallin.

2. Composant micromécanique selon la revendication 1, **caractérisé en ce que** la structure mobile (2) comprend une pluralité de couches de départ supplémentaires (4', 4") et une pluralité de couches supplémentaires (5', 5) respectivement formées par croissance sur les couches de départ supplémentaires (4', 4").

3. Composant micromécanique selon l'une quelconque des revendications précédentes, **caractérisé en ce que** la structure mobile (2) comporte des régions (2') au moins partiellement soumises à une sous-gravure.

4. Composant micromécanique selon l'une quelconque des revendications précédentes, **caractérisé en ce que** le substrat (1) présente au moins un évidement (1') au moins partiellement dans une surface de projection de la structure mobile perpendiculairement à un plan d'extension principal (100) du substrat.

5. Composant micromécanique selon l'une quelconque des revendications précédentes, **caractérisé en ce que** la structure mobile (2) comporte au moins une couche de compensation (6), préférablement constituée d'oxyde de silicium, de nitrure de silicium et/ou de carbure de silicium, qui est préférablement disposée dans la région d'une couche de départ supplémentaire (4', 4") et plus préférablement, entre une couche de départ supplémentaire (4', 4") et une couche (5) ou une couche supplémentaire (5', 5") disposée perpendiculairement au plan d'extension principal (100) dans la direction du substrat (2).

6. Composant micromécanique selon l'une quelconque des revendications précédentes, **caractérisé en ce que** le composant micromécanique comprend un capteur et plus particulièrement, un capteur d'accélération, un capteur de vitesse de rotation, un capteur à membrane et/ou un micro-miroir.

7. Composant micromécanique selon l'une quelconque des revendications précédentes, **caractérisé en ce que** l'élément mobile (2) est électriquement isolé du substrat (2).

8. Composant micromécanique selon l'une quelconque des revendications précédentes, **caractérisé en ce que** les couches (5, 5', 5") sont dopées et/ou **en ce que** les couches (5, 5', 5") présentent respectivement des épaisseurs de couches identiques ou différentes perpendiculairement au plan d'extension principal (100).

9. Procédé de fabrication d'un composant micromécanique selon l'une quelconque des revendications précédentes, **caractérisé en ce que**, lors d'une première étape de procédé, le substrat (1) est fourni, dans lequel, lors d'une deuxième étape de procédé, le substrat (1) est au moins partiellement muni de la couche de départ (4), dans lequel, lors d'une troisième étape de procédé, la couche (5) est déposée sur la couche de départ (4), dans lequel, lors d'une quatrième étape de procédé, la couche (5) est munie de la couche de départ supplémentaire (4') et dans lequel, lors d'une cinquième étape de procédé, la couche supplémentaire (5') est déposée sur la couche de départ supplémentaire (4').

10. Procédé selon la revendication 9, **caractérisé en ce que**, lors d'une sixième et d'une septième étape de procédé, une pluralité de couches de départ supplémentaires (4', 4") et de couches supplémentaires (5', 5") sont déposées en alternance les unes après les autres.

11. Procédé selon l'une quelconque des revendications 9 ou 10, **caractérisé en ce que**, lors d'une huitième étape de procédé, une couche de compensation est déposée sur la couche (5) ou sur une couche supplémentaire (5', 5") et/ou **en ce que**, lors d'une neuvième étape de procédé, la couche de départ (4) ou une couche de départ supplémentaire (4', 4") est structurée, dopée, soumise à une sous-gravure, recuite, rendue rugueuse et/ou polie.

12. Procédé selon l'une quelconque des revendications 9 à 11, **caractérisé en ce que**, lors d'une dixième étape de procédé, l'évidement (1') est formé par sous-gravure dans le substrat (1).

13. Procédé selon l'une quelconque des revendications 9 à 12, **caractérisé en ce que**, lors d'une onzième étape de procédé, les couches et/ou les couches supplémentaires (5, 5', 5") sont au moins partiellement dopées.
